# EUROPEAN PATENT APPLICATION

(11) **EP 2 492 972 A2**
(43) Date of publication of application: **29.08.2012**
(21) Application number: 11167414.9
(22) Date of filing: 25.05.2011
(51) Int. Cl.: H01L 33/00, H01L 33/12, H01L 33/16

(54) **Method of manufacturing GaN powder and nitride-based light emitting device using GaN powder manufactured by the method**

(30) Priority: 28.02.2011 KR 20110018225
(71) Applicant: Semi-Materials Co., Ltd, Seongnam-si, Gyeonggi-do 463-400 (KR); Park, Kun, Bundang-gu Sengnam-si, Gyeonggi-do 463-440 (KR)
(72) Inventor: Jin, Joo, Gyeonggi-do 449-853 (KR)
(74) Representative: Müller Schupfner & Partner

(57) **Abstract**

Disclosed herein is a method of manufacturing GaN powders using a GaN etching product produced during manufacture of a GaN-based light emitting device. The method includes collecting a GaN etching product produced during etching of the GaN-based light emitting device, cleaning the collected GaN etching product; heating the cleaned GaN etching product to remove indium (In) components from the GaN etching product, and pulverizing the GaN etching product having the indium components removed therefrom into powders. A nitride-based light emitting device using the GaN powders is also disclosed.

## Description

### 1. Technical Field

The present invention relates to a technique for manufacturing gallium nitride (GaN) powders and a technique for manufacturing a nitride-based light emitting device.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. Nitride-based light emitting devices can realize a variety of colors due to high band-gap energy thereof. Further, nitride-based light emitting devices exhibit excellent thermal stability.

Nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a top-bottom arrangement of the n-electrode and the p-electrode.

### BRIEF SUMMARY

One aspect of the present invention is to provide a method of easily manufacturing GaN powders using a GaN etching product produced during manufacture of a GaN-based light emitting device.

Another aspect of the present invention is to provide a nitride-based light emitting device using the GaN powders manufactured from the GaN etching product.

In accordance with one aspect of the invention, a method of manufacturing GaN powders includes: collecting a GaN etching product produced during etching of a GaN-based light emitting device; cleaning the collected GaN etching product; heating the cleaned GaN etching product to remove indium (In) components from the GaN etching product; and pulverizing the GaN etching product having the indium components removed therefrom into powders.

In accordance with another aspect of the invention, a nitride-based light emitting device includes a growth substrate; a GaN powder layer formed of GaN powders on the growth substrate; and a light emitting structure formed on the GaN powder layer and having a plurality of nitride layers stacked therein. Here, the GaN powders are prepared by cleaning, heating and pulverizing a GaN etching product produced during etching of a GaN-based light emitting device.

According to a further aspect of the invention, a nitride-based light emitting device includes: a growth substrate; a GaN powder layer formed of GaN powders on the growth substrate; a p-type nitride layer on the GaN powder layer; a light emitting active layer on the p-type nitride layer; and an n-type ZnO layer on the light emitting active layer. Here, the GaN powders are prepared by cleaning, heating and pulverizing a GaN etching product produced during etching of a GaN-based light emitting device.

### BRIEF DESCRIPTION OF THE DRAWINGS

The above and other aspects, features and advantages of the invention will become apparent from the detailed description of the following embodiments in conjunction with the accompanying drawings:
Fig. 1 is a sectional view of a general lateral type nitride-based light emitting device;
Fig. 2 illustrates a region to be etched during manufacture of the lateral type nitride-based light emitting device;
Fig. 3 is a schematic flowchart of a method of manufacturing GaN powders according to an exemplary embodiment of the present invention;
Fig. 4 is a sectional view of one exemplary embodiment of a nitride-based light emitting device using GaN powders according to the present invention; and
Fig. 5 is a sectional view of another exemplary embodiment of a nitride-based light emitting device using GaN powders according to the present invention.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

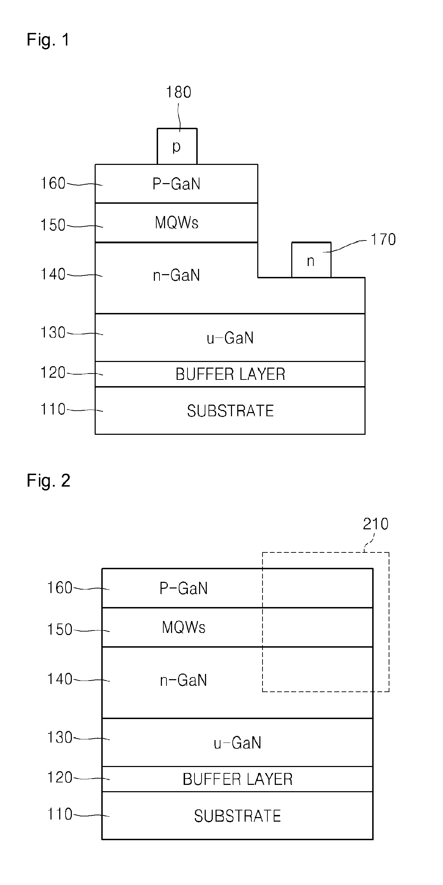

Fig. 1 is a sectional view of a general lateral type nitride-based light emitting device, in which GaN is used as a nitride.

Referring to Fig. 1, the lateral type nitride-based light emitting device includes a substrate 110, a buffer layer 120, a u-GaN layer 130, an n-GaN layer 140, a light emitting active layer 150, and a p-GaN layer 160 stacked from the bottom of the light emitting device. Further, the light emitting device includes an n-electrode 170 on the n-GaN layer 140 and a p-electrode 180 on the p-GaN layer 160.

In the lateral type nitride-based light emitting device shown in Fig. 1, the n-GaN layer 140 must be exposed to form the n-electrode 170.

Fig. 2 illustrates a region to be etched during manufacture of the lateral type nitride-based light emitting device. To expose the n-GaN layer 140, some regions 210 of the p-GaN layer 160, the light emitting active layer 150 and the n-GaN layer 140 are removed by etching, as shown in Fig. 2. Etching may be performed by inductively coupled plasma (ICP) etching or the like.

In this invention, an etching product produced during manufacture of the GaN-based light emitting device is used in a method of manufacturing GaN powders.

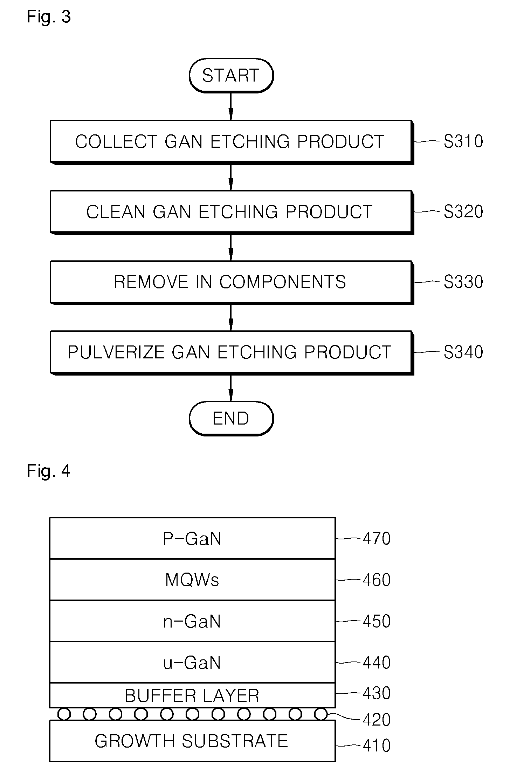

Fig. 3 is a schematic flowchart of a method of manufacturing GaN powders according to an exemplary embodiment of the present invention.

Referring to Fig. 3, the method of manufacturing GaN powders includes collecting a GaN etching product in operation S310, cleaning the GaN etching product in operation S320, removing indium (In) components from the GaN etching product in operation S330, and pulverizing the GaN etching product in operation S340.

In operation S310, the GaN etching product produced during manufacture of a GaN-based light emitting device is collected using a trap or filter.

In operation S320, foreign matter is cleaned from the GaN etching product.

Cleaning the GaN etching product may be performed in a variety of ways. For example, the GaN etching product may be cleaned by an ultrasonic cleaning process using acetone or methyl alcohol. This process provides excellent cleaning efficiency.

Next, in operation S330, the indium (In) components are removed from the GaN etching product. Since the indium components are generally contained in a light emitting active layer, the indium component may be removed from the GaN etching product to improve purity of the GaN powders. Removal of the indium components may be carried out by heating the GaN etching product.

Heating may be performed at a temperature of 900~1250°C. If the heating temperature is less than 900°C, it takes a long time to achieve complete removal of the indium components. Further, if the heating temperature exceeds 1250°C, there is a problem in that the device configuration for removing the indium components becomes complicated.

Then, in operation S340, the GaN etching product having the indium components removed therefrom is pulverized to produce GaN powders.

Here, pulverization may be performed using a ball-mill or the like. Further, pulverization may be performed such that the produced GaN powders have an average particle size of 10 nm ~ 1 µm. This average particle size of the GaN powders is determined in consideration of a preferable average particle size of the GaN powders in the range of 10 nm ~ 1 µm for the nitride-based light emitting device using the GaN powder described below

As described above, in this embodiment of the invention, the GaN powders are produced using the GaN product which is formed during manufacture of the GaN-based light emitting device. Accordingly, it is possible to produce high purity GaN powders through simple processes of collecting, cleaning, indium removing and pulverizing the GaN etching product.

The produced GaN powders may be used for a lattice buffering layer of the nitride-based light emitting device.

Fig. 4 is a sectional view of one embodiment of a nitride-based light emitting device using GaN powders according to the present invention.

Referring to Fig. 4, the nitride-based light emitting device according to this embodiment includes a growth substrate 410, a GaN powder layer 420, and a light emitting structure 430, 450, 460, 470.

In this embodiment, the growth substrate 410 may be a sapphire substrate which is widely used as a growth substrate in manufacture of nitride-based light emitting devices. Further, in this embodiment, the growth substrate 410 may be a silicon substrate such as a single crystal silicon substrate, a polycrystal silicon substrate, and the like.

A GaN powder layer 420 is formed of GaN powders on the growth substrate 410.

Here, the GaN powders may be prepared by cleaning, heating, and pulverizing a GaN etching product which is produced during manufacture of a GaN-based light emitting device.

The GaN powder layer 420 serves to reduce dislocation density during growth of a nitride layer by reducing lattice mismatch caused by a difference in lattice constant between the nitride layer and the growth substrate.

For example, when a silicon substrate is used as the growth substrate, there is a great difference in lattice constant between the silicon substrate and the nitride layer. As a result, when growing the nitride layer on the silicon substrate, dislocation density becomes very high, thereby causing low luminescence efficiency of the light emitting device.

As the GaN powder layer is formed on the growth substrate and the nitride layer is then grown on the GaN powder layer, lattice mismatch can be relieved to reduce dislocations during nitride growth.

Further, when growing a nitride layer on the GaN powder layer, the nitride layer is initially grown in the vertical direction and then grows in the horizontal direction, thereby enabling growth of a flat nitride layer.

The GaN powders may be attached or secured to the growth substrate 410 by spin coating or the like.

To allow the GaN powders to be easily attached or secured to the growth substrate 410, the growth substrate 410 may have an uneven surface with prominences and depressions. The surface unevenness may be formed as a specific or random pattern. The surface unevenness of the growth substrate 410 may be formed by various methods such as etching and the like.

When the growth substrate 410 has the uneven surface, the GaN powders may be easily attached or secured to the depressions on the surface of the growth substrate 410.

Next, a method for forming the GaN powder layer 420 will be described in more detail.

First, GaN powders are coated on a growth substrate using a spin-coater or the like. Then, the growth substrate is heated to about 800~1200°C in an ammonia atmosphere within a chamber, for example a CVD chamber, such that the GaN powders are attached to the growth substrate. In this case, the growth substrate may be subjected to slight etching to form an uneven surface. The surface unevenness of the growth substrate facilitates attachment or securing of the GaN powders thereto.

Alternatively, the GaN powder layer may be formed using a GaN powder-containing solution by spin-coating the solution onto the growth substrate and drying the growth substrate. Here, the GaN powder-containing solution may be prepared using various solvents, such as acetone, methanol, ethylene glycol, and the like.

Either or both of the methods described above may be selectively used to form the GaN powder layer using the GaN powders. For example, the GaN powder layer may be formed by spin-coating the GaN powder-containing solution onto the growth substrate and drying the growth substrate, followed by heating the growth substrate in a chamber.

The GaN powders may have an average particle size of 10 nm ~ 1 µm. The smaller the average particle size of the powders, the better the effect of suppressing occurrence of dislocations during nitride growth. If the average particle size of GaN powders exceeds 1 µm, the effect of suppressing occurrence of dislocations is insufficient, causing low luminescence efficiency of the manufactured nitride-based light emitting device. If the average particle size of GaN powders is less than 10 nm, manufacturing costs of the GaN powders become excessively high, thereby causing an increase in manufacturing costs of the nitride-based light emitting device.

Then, the light emitting structure 430~470 is formed on the GaN powder layer 420.

The light emitting structure is formed by stacking a plurality of nitride layers. More specifically, the light emitting structure includes a first conductive type nitride layer 450, a light emitting active layer 460, and a second conductive type nitride layer 470.

The first conductive type nitride layer 450 may be formed on the GaN powder layer 420.

The first conductive type nitride layer 450 may exhibit characteristics of an n-type or p-type layer according to impurities doped therein. For example, if the first conductive type nitride layer 450 is formed by doping an n-type impurity such as silicon (Si) into a nitride layer, the first conductive type nitride layer 450 exhibits characteristics of the n-type semiconductor. On the other hand, if the first conductive type nitride layer 450 is formed by doping a p-type impurity such as magnesium (Mg) into a nitride layer, the first conductive type nitride layer 450 exhibits characteristics of the p-type layer.

The light emitting active layer 460 is formed on the first conductive type nitride layer 450. The light emitting active layer 460 may have a multiple quantum well (MQW) structure. For example, the light emitting active layer 460 may have a structure having InₓGa₁₋ₓN (0.1≤×≤0.3) and GaN alternately stacked one above another.

In the light emitting active layer 460, electrons traveling through the n-type nitride layer recombine with holes traveling through the p-type nitride layers to generate light.

The second conductive type nitride layer 470 is formed on the light emitting active layer 460 and exhibits opposite electrical characteristics to those of the first conductive type nitride layer 450.

For example, if the first conductive type nitride layer 450 is an n-type GaN layer, the second conductive type nitride layer 470 may be a p-type GaN layer. The n-type GaN layer may be formed by doping Si into a GaN layer and the p-type GaN layer may be formed by doping Mg into the GaN layer.

As such, if the first conductive type nitride layer 450 is the n-type GaN layer and the second conductive type nitride layer 470 is the p-type GaN layer, an n-type silicon substrate may be adopted as the growth substrate 410. When the n-type silicon substrate is adopted, n-type layers may be formed as the respective layers under the light emitting active layer 460. Further, when the n-type silicon substrate is adopted, the silicon substrate may be used as an n-electrode, thereby eliminating a process of removing the substrate and a process of forming the n-electrode. Accordingly, when adopting the n-type silicon substrate, it is possible to easily fabricate not only the lateral type light emitting device but also a vertical type light emitting device which has a relatively wide light emitting area to easily realize high brightness light emission.

Further, when the n-type silicon substrate is used as the growth substrate, the n-type silicon substrate is subjected to insignificant bowing during nitride growth at high temperature, thereby enabling uniform growth of the nitride layer.

The light emitting structure shown in Fig. 4 may further include a buffer layer 430 on the GaN powder layer 420. In this case, the first conductive type nitride layer 450 is formed on the buffer layer 430.

The buffer layer 430 serves to relieve stress generated during growth of the nitride layer, which is a hetero-material, on the growth substrate. The buffer layer 430 may be formed of a nitride material such as AIN, ZrN, GaN, and the like.

If the first conductive type nitride layer 450 is an n-type nitride layer, the buffer layer 430 may also be an n-type nitride layer. Nitrides for the buffer layer 430 generally have high electric resistance. However, if the buffer layer 430 is the n-type nitride layer, the buffer layer has low electric resistance. Accordingly, it is possible to improve operational efficiency of the nitride-based light emitting device.

Particularly, when the n-type silicon substrate is used as the growth substrate 410, since electrons injected into the growth substrate 410 can easily reach the light emitting active layer without interference of a barrier, it is possible to further improve operational efficiency of the light emitting device.

Further, an undoped nitride layer 440 may be formed on the buffer layer 430 to further facilitate lattice matching. In this case, the first conductive type nitride layer 450 is formed on the undoped nitride layer 440. The undoped nitride layer 440 may be used with an undoped substrate.

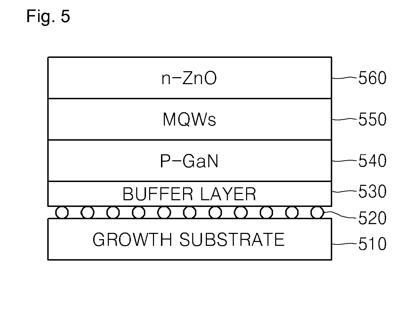

Fig. 5 is a sectional view of another embodiment of a nitride-based light emitting device using GaN powders according to the present invention.

Referring to Fig. 5, the nitride-based light emitting device according to this embodiment includes a growth substrate 510, a GaN powder layer 520, a p-type nitride layer 540, a light emitting active layer 550, and an n-type ZnO layer 560.

In the embodiment shown in Fig. 5, the growth substrate 510 and the GaN powder layer 520 are the same as the growth substrate 410 and the GaN powder layer 420 shown in Fig. 4, and a detailed description thereof will thus be omitted herein.

The p-type nitride layer 540 is formed on the GaN powder layer 520. The p-type nitride layer 540 is formed by doping a p-type impurity such as magnesium (Mg) to guarantee electrical characteristics of the p-type layer.

Conventionally, in the method of manufacturing a nitride-based light emitting device, the p-type nitride layer is formed at the last stage after the light emitting active layer is formed. Here, the p-type nitride layer is grown at a decreased growth temperature to suppress influence of the p-type impurity on the light emitting active layer during formation of the p-type nitride layer. As a result, crystal quality of the p-type nitride layer is deteriorated, causing deterioration of light emitting efficiency.

In the embodiment shown in Fig. 5, however, the p-type nitride layer 540 is formed before the light emitting active layer 550, thereby ensuring high crystal quality of the p-type nitride layer.

The light emitting active layer 550 is formed on the p-type nitride layer 540. The light emitting active layer 550 may have a multiple quantum well (MQW) structure. For example, the light emitting active layer 550 may have a structure having InₓGa₁₋ₓN (0.1≤x≤0.3) and GaN alternately stacked one above another or a structure having InₓZn₁₋ₓO (0.1≤x≤0.3) and ZnO alternately stacked one above another.

The n-type ZnO layer 560 is formed on the light emitting active layer 550 and exhibits electrical characteristics of an n-type layer opposite to those of the p-type nitride layer 540. Although ZnO is an n-type material, ZnO has insignificant electrical characteristics compared with those of the n-type layer formed using n-type impurities and may act merely as a current path. Thus, n-type impurities such as silicon (Si) may be doped into the n-type ZnO layer 560.

ZnO has a Wurtzite crystal structure, which is substantially the same as the crystal structure of GaN. Further, since ZnO can be grown at about 700~800°C, it is possible to improve crystal quality by minimizing influence on the light emitting active layer 550 during growth of ZnO. Accordingly, the n-type ZnO layer 560 of this embodiment may replace an n-type GaN layer, which is grown at high temperature of about 1200°C.

Further, application of the n-type ZnO layer 560 results in further improvement of brightness as compared with the case where the n-type GaN layer is used.

As such, in the embodiment of Fig. 5, the p-type nitride layer 540 is first formed on the growth substrate 510 and the n-type ZnO layer 560 is then formed on the light emitting active layer 550.

At this time, a p-type silicon substrate may be adopted as the growth substrate 510. When the p-type silicon substrate is adopted, p-type layers may be formed as the respective layers under the light emitting active layer 550. Further, when the p-type silicon substrate is adopted, the silicon substrate may act as a p-electrode, thereby eliminating a process of removing the substrate and a process of forming the p-electrode, even in manufacture of a vertical light emitting device.

Accordingly, when adopting the p-type silicon substrate, it is possible to easily fabricate not only the lateral type light emitting device but also the vertical type light emitting device which has a relatively wide light emitting area to easily realize emission of light with high brightness.

On the other hand, the light emitting structure shown in Fig. 5 may further include a nitride buffer layer 530 between the GaN powder layer 520 and the p-type nitride layer 540. Obviously, the buffer layer 530 may be a p-type buffer layer.

Particularly, when the buffer layer 530 is the p-type buffer layer and the p-type silicon substrate is adopted as the growth substrate 510, holes can travel from the p-type silicon substrate 510 to the light emitting active layer 550 without interference of a barrier, thereby further improving operational efficiency of the light emitting device.

Further, when the buffer layer 530 is the p-type buffer layer, impurities such as magnesium (Mg) in the buffer layer 530 may move into the growth substrate 510. In this case, the substrate has electrical characteristics of the p-type layer. Accordingly, even if a sapphire substrate having insulation properties is used as the growth substrate 510, there is no need for removal of the sapphire substrate, unlike in manufacture of conventional vertical type light emitting devices.

As set forth above, in the method of manufacturing a nitride-based light emitting device according to the embodiments, a GaN powder layer is formed of GaN powders, thereby minimizing occurrence of dislocations caused by a difference in lattice mismatch between a silicon substrate and a nitride layer during growth of the nitride layer. Accordingly, it is possible to improve light extraction efficiency of the manufactured nitride-based light emitting device.

As such, according to the embodiments, the GaN powder manufacturing method employs the GaN etching product produced during fabrication of a GaN-based light emitting device, so that expensive GaN powders can be prepared through a simple process.

Further, according to the embodiments, the nitride-based light emitting device includes the GaN layer formed using the GaN powders prepared from the GaN etching product, thereby minimizing occurrence of dislocations due to a difference in lattice constant between the silicon substrate and the nitride layer during growth of the nitride layer.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A method of manufacturing GaN powders, **characterized in that** a GaN etching product produced during etching of a GaN-based light emitting device is used as a raw material of the GaN powders.

2. The method of claim 1, **characterized by** comprising:
collecting the GaN etching product produced during etching of the GaN-based light emitting device;
cleaning the collected GaN etching product;
heating the cleaned GaN etching product to remove indium (In) components from the GaN etching product; and
pulverizing the GaN etching product having the indium components removed therefrom into powders.

3. The method of claim 2, **characterized in that** the cleaning the collected GaN etching product is performed by ultrasonic cleaning using acetone or methyl alcohol.

4. The method of claim 2, **characterized in that** the heating the cleaned GaN etching product is performed by heating the GaN etching product to a temperature of 900~1250°C.

5. The method of claim 2, **characterized in that** the pulverizing the GaN etching product is performed such that the produced GaN powders have an average particle size of 10 nm ~ 1 µm.

6. A nitride-based light emitting device including a GaN powder layer between a growth substrate and a light emitting structure, **characterized by** comprising:
a growth substrate;
a GaN powder layer formed of GaN powders on the growth substrate; and
a light emitting structure formed on the GaN powder layer and having a plurality of nitride layers stacked therein,
the GaN powders of the GaN powder layer being prepared by cleaning, heating and pulverizing a GaN etching product produced during etching of a GaN-based light emitting device.

7. The nitride-based light emitting device of claim 6, **characterized in that** the light emitting structure comprises a buffer layer formed on the GaN powder layer; an n-type nitride layer formed on the buffer layer; a light emitting active layer formed on the n-type nitride layer; and a p-type nitride layer formed on the light emitting active layer.

8. The nitride-based light emitting device of claim 7, **characterized in that** the growth substrate is an n-type silicon substrate.

9. The nitride-based light emitting device of claim 7, **characterized in that** the buffer layer is formed of an n-type nitride.

10. The nitride-based light emitting device of claim 7, **characterized in that** the light emitting structure further comprise an undoped nitride layer between the buffer layer and the n-type nitride layer.

11. A nitride-based light emitting device including a GaN powder layer between a growth substrate and a p-type light emitting structure, **characterized by** comprising:
a growth substrate;
a GaN powder layer formed of GaN powders on the growth substrate;
a p-type nitride layer formed on the GaN powder layer;
a light emitting active layer formed on the p-type nitride layer; and
an n-type ZnO layer formed on the light emitting active layer,
the GaN powders of the GaN powder layer being prepared by cleaning, heating and pulverizing a GaN etching product produced during etching of a GaN-based light emitting device.

12. The nitride-based light emitting device of claim 11, **characterized in that** the growth substrate is a p-type silicon substrate.

13. The nitride-based light emitting device of claim 11, **characterized by** further comprising: a buffer layer between the GaN powder layer and the p-type nitride layer and formed of a nitride.

14. The nitride-based light emitting device of claim 13, **characterized in that** the buffer layer is formed of a p-type nitride.
